Europäisches Patentamt

European Patent Office

Office européen des brevets

(11) Veröffentlichungsnummer: **0 276 394 B1**

# (12) EUROPÄISCHE PATENTSCHRIFT

(45) Veröffentlichungstag der Patentschrift: **03.02.93**

(21) Anmeldenummer: **87116927.2**

(22) Anmeldetag: **17.11.87**

(51) Int. Cl.⁵: **H03H 17/02**

(54) **Übertragungsanordnung für digitale Signale.**

(30) Priorität: **26.01.87 DE 3702215**

(43) Veröffentlichungstag der Anmeldung:
**03.08.88 Patentblatt 88/31**

(45) Bekanntmachung des Hinweises auf die
Patenterteilung:
**03.02.93 Patentblatt 93/05**

(84) Benannte Vertragsstaaten:
**AT GB NL**

(56) Entgegenhaltungen:
**EP-A- 0 135 066**
**US-A- 4 621 366**

**FIRST EUROPEAN SIGNAL PROCESSING
CONFERENCE PROCEEDINGS, 16.-18. September 1980, Seiten 123-129, Lausanne,
North-Holland Publishing Co., Amsterdam,
NI; H. SCHUSSLER: "Implementation of variable digital filters"**

**IEEE TRANSACTIONS ON INFORMATION
THEORY, Band IT-17, Nr. 4, Juli 1971, Seiten
431-439, IEEE, New York, US; T.J. SCHONFELD et al.: "A rapidly converging first-order
training algorithm for adaptive equalizer"**

(73) Patentinhaber: **ANT Nachrichtentechnik GmbH
Gerberstrasse 33
W-7150 Backnang(DE)**

(72) Erfinder: **Rabenstein, Rudolf, Dipl.-Ing.
Am Erlanger Weg 56
W-8520 Erlangen(DE)**

Rank Xerox (UK) Business Services

**Beschreibung**

Die Erfindung betrifft eine Übertragungsanordnung für digitale Signale nach dem Oberbegriff des Anspruches 1. Eine solche Übertragungsanordnung ist im allgemeinen bei digitaler Filterung, aber auch bei Pegeleinstellung, anwendbar, wobei Filterparameter (also ein Koeffizientensatz eines Übertragungsgliedes) während des Betriebes umgeschaltet werden. Als digitale Signale kommen Sprach-, Musik-, aber auch nichthörbare Signale in Betracht.

Die einfachste Methode, die Übertragungsfunktion einer Übertragungsanordnung für digitale Signale während des Betriebs zu ändern, besteht darin, zwischen zwei Abtastzeitpunkten den gesamten Koeffizientensatz auszutauschen. Eine solche abrupte, momentane Umschaltung des Koeffizientensatzes führt jedoch ohne spezielle Maßnahmen für eine Störunterdrückung zu Störungen im Ausgangssignal der Übertragungsanordnung, und zwar - beispielsweise bei Audiosignalen - zu Störungen, die für das Gehör unangenehm sind. Es entstehen beispielsweise Knackgeräusche, die je nach vorliegender Konfiguration und zufälliger Wahl des Umschaltzeitpunktes mehr oder weniger unangenehm in Erscheinung treten.

Es ist denkbar, solche Störungen durch Einschalten von Störunterdrückungsgliedern in den Weg für die digitalen Signale zu reduzieren. Solche Lösungen haben sich aber als nicht voll befriedigend erwiesen, da sie auch das Nutzsignal in unerwünschter Weise beeinflussen.

Dagegen ist in der Deutschen Offenlegungsschrift DE-A-3 333 274 vorgeschlagen worden, parallel zum Übertragungsglied, dessen Koeffizientensatz umschaltbar sein sollte, einen zweiten Zweig mit einem zweiten digitalen Übertragungsglied vorzusehen. Wird eine Veränderung der Übertragungsfunktion des ersten Übertragungsgliedes gewünscht, so werden statt einer Änderung der Koeffizienten des ersten Übertragungsgliedes die Koeffizienten des zweiten Übertragungsgliedes auf die gewünschten Werte umgeschaltet. Die Ausgangsgröße des zweiten Übertragungsgliedes wird aber über Umschaltmittel erst dann an den Ausgang der Übertragungsanordnung weitergeleitet, wenn ein Diskriminator, der um die Einschwingzeit des zweiten Übertragungsgliedes verzögert wirksam geschaltet wird, nach einem Vergleich der Ausgangsgrößen der beiden Übertragungsglieder die Umschaltung der Umschaltmittel bewirkt.

Diese Übertragungsanordnung hat jedoch eine Reihe von Nachteilen, deren schwerwiegendster ist, daß der Hardware- oder Rechenaufwand verdoppelt werden muß, um die Koeffizientenumschaltung zu ermöglichen.

In der Europäischen Patentanmeldung EP-A-0 135 066 ist vorgeschlagen worden, daß den Übertragungsgliedern über Umschaltmittel Zwischenkoeffizienten (gebildet durch Interpolationswerte zwischen einem Anfangs- und einem Endkoeffizientensatz) zugeordnet werden, die dafür sorgen sollen, daß die Übertragungsfunktion des Übertragungsgliedes sich in kleinen Schritten von einer Anfangs- bis zu einer Endübertragungsfunktion verändert.

Auch diese Übertragungsanordnung hat noch einige Nachteile:

1. Um eine deutliche Verbesserung gegenüber einem abrupten Umschalten zu erzielen, sind in manchen Fällen relativ viele Zwischenschritte notwendig.

2. Während dieser Zwischenschritte werden die Übertragungskoeffizienten unabhängig voneinander zwischen ihren jeweiligen Anfangs- und Endwerten linear interpoliert. Dabei können die diesen Zwischenkoeffizienten zugeordneten Übertragungsfunktionen unter Umständen erheblich mehr von den Anfangs- oder Endübertragungsfunktionen abweichen als diese beiden voneinander. Dadurch kann es während des Umschaltvorganges zu erheblichen Störsignalen kommen.

3. Für die Gewinnung der Zwischenkoeffizienten sind spezielle Interpolationsmittel notwendig.

Der vorliegenden Erfindung lag die Aufgabe zugrunde, eine Übertragungsanordnung der eingangs genannten Art anzugeben, die bei möglichst geringem Rechen- und Schaltungsaufwand eine möglichst störungsarme Umschaltung ermöglicht.

Die Lösung dieser Aufgabe erfolgt durch die kennzeichnenden Merkmale des Anspruches 1. Vorteilhafte Ausgestaltungen ergeben sich durch die Unteransprüche.

Die erfindungsgemäße Anordnung hat den Vorteil einer störungsarmen Umschaltung, wobei der Aufwand relativ gering ist. Außerdem wird ein sehr schnelles Umschalten ermöglicht, im Extremfall innerhalb zweier Abtastzeitpunkte.

Es folgt nun die Beschreibung der Erfindung anhand der Figuren.

Die Figur 1 zeigt eine schematisch dargestellte Übertragungsanordnung.

Die Figur 2 enthält drei Übertragungsanordnungen, denen drei verschiedene Koeffizientensätze zugeordnet sind und von deren Ausgangssignalen Differenzsignale gebildet werden, welche nach den Vorschriften der Ansprüche 3, 4 und 5 zu minimieren sind. Die Realisierung der Erfindung erfolgt nach Figur 1, während Figur 2 lediglich der Erläuterung der verwendeten Bezeichnungen dient.

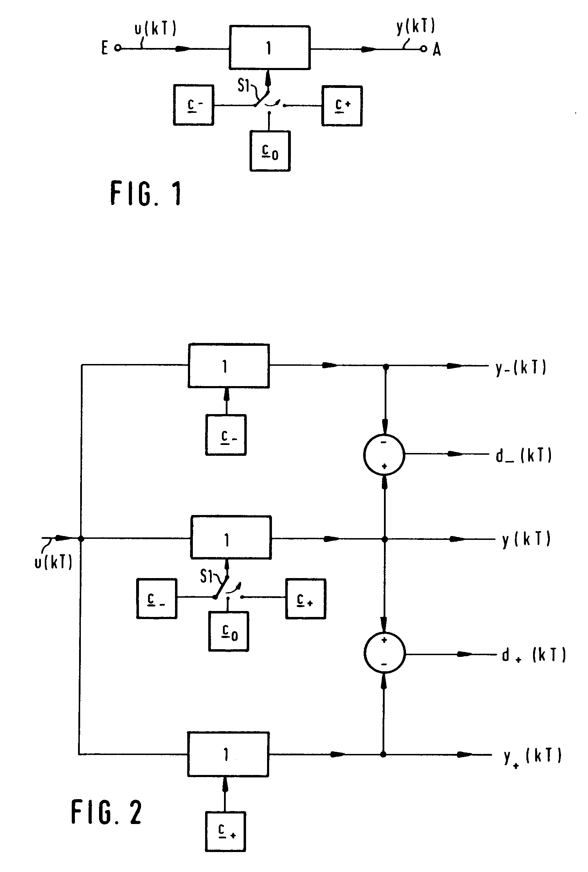

Bei der Übertragungsanordnung nach Figur 1 steht das digitale Eingangssignal $u(kT)$ an seinem

2

Eingang E an, aus welchem ein übertragungsglied 1 ein digitales Ausgangssignal y(kT) erzeugt. Dem übertragungsglied 1 können über Umschaltmittel S1 nacheinander drei verschiedene Koeffizientensätze zugeordnet werden, beginnend mit einem Anfangskoeffizientensatz $c_-$ über einen Zwischenkoeffizientensatz $c_\emptyset$ bis zu einem Endkoeffizientensatz $c_+$. Während der Anfangs- und der Endkoeffizientensatz von der Anwendung der vorgegeben sind, wird der Zwischenkoeffizientensatz nach den Vorschriften her Ansprüche 3, 4 oder 5 so gewählt, daß die Störungen bei der Umschaltung möglichst klein sind. Verschiedene mathematische Beschreibungen der Störsignale werden in Figur 2 erläutert.

Die Figur 2 zeigt eine Anordnung von drei parallelgeschalteten übertragunsgliedern 1, welchen ebenfalls das Eingangssignal u(kT) gemeinsam zugeführt wird. Das obere und das untere übertragungsglied 1 werden mit konstanten Koeffizienten (d.h. ohne Umschaltung) betrieben, wobei dem oberen übertragungsglied der Anfangskoeffizientensatz $c_-$ und dem unteren übertragungsglied der Endkoeffizientensatz $c_+$ zugeordnet ist. Dem mittleren übertragungsglied sind die drei Koeffizientensätze $c_-$, $c_\emptyset$ und $c_+$ zugeordnet, die wie in Figur 1 beschrieben umgeschaltet werden. Das obere übertragungsglied hat das Ausgangssignal $y_-(kT)$, das ist das Ausgangssignal der Übertragungsanordnung vor dem Umschaltzeitpunkt.

Das untere übertragungsglied erzeugt ein Ausgangssignal $y_+(kT)$, welches dem Ausgangssignal der Übertragungsanordnung nach dem Umschaltzeitpunkt entspricht. Das mittlere übertragungsglied erzeugt ein Ausgangssignal y(kT), welches dem Ausgangssignal der Übertragungsanordnung entspricht, wenn ihm entprechend der Figur 1 die Anfangs-, Zwischen- und Endkoeffizentensätze umschaltbar zugeordnet werden. Mittels zweier Subtrahierglieder werden nun die Differenzen $d_-(k) = y(k) - y_-(k)$ und $d_+(k) = y(k) - y_+(k)$ gebildet, die als Differenzsignale gemäß den Vorschriften der Ansprüche 3, 4 und 5 zur Berechnung der Minimierung herangezogen werden.

Beispiel

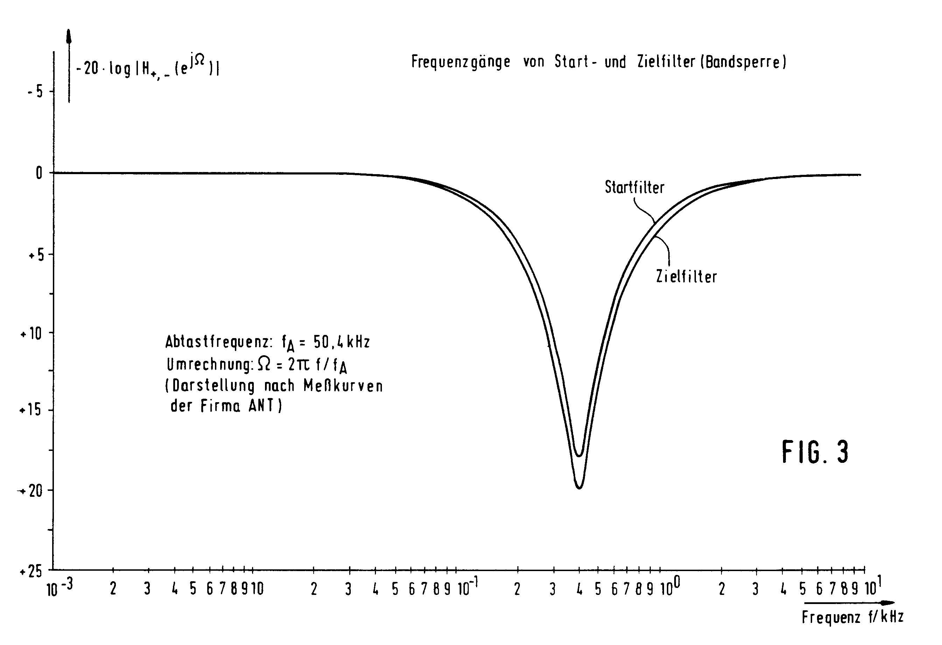

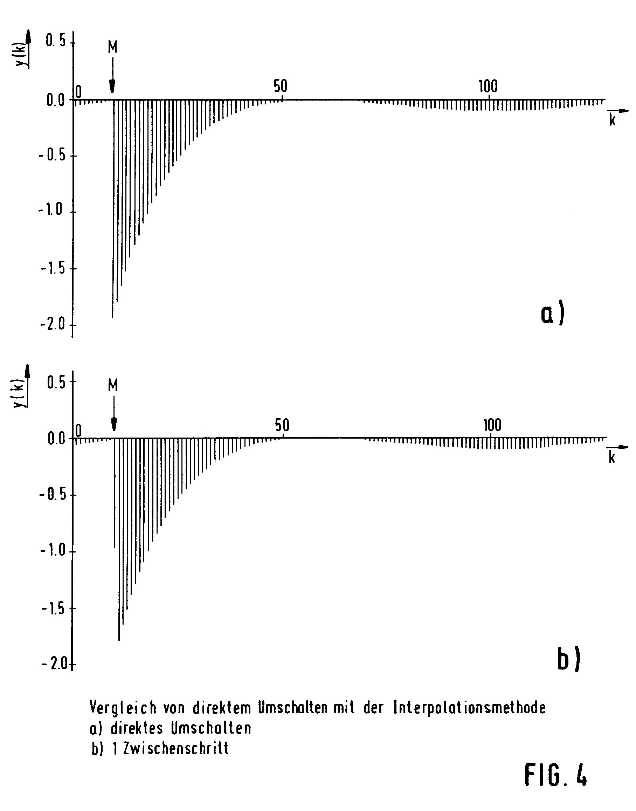

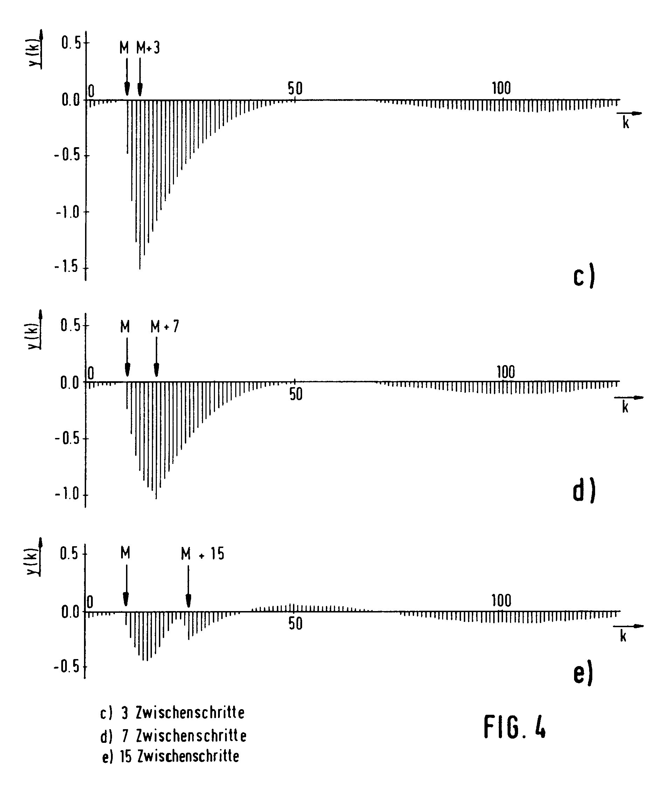

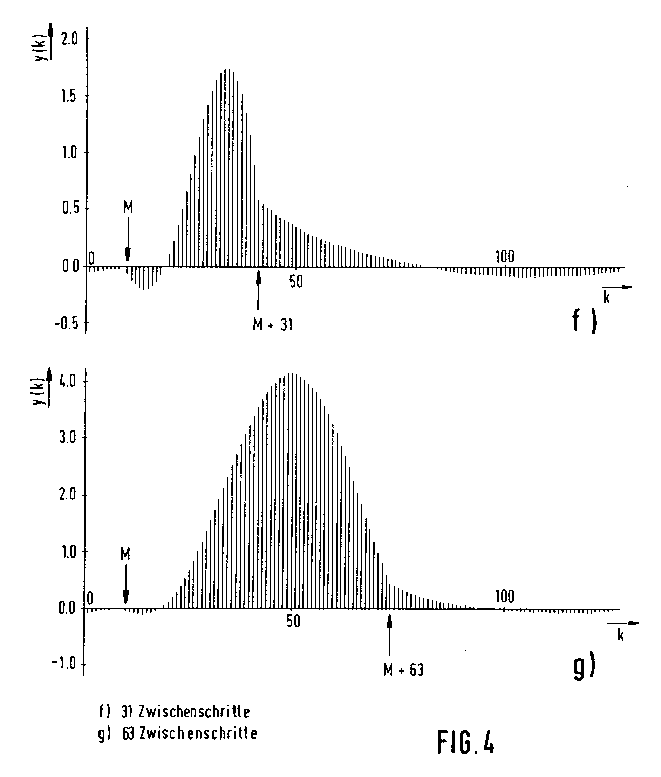

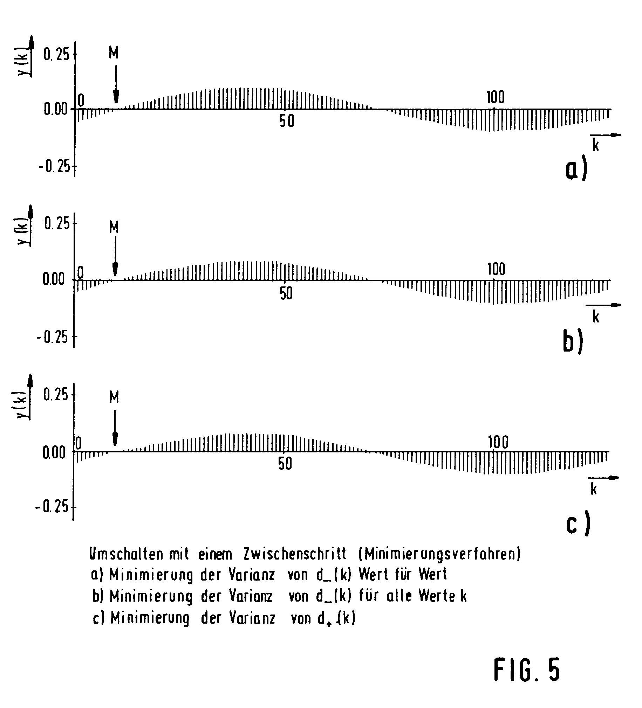

Die Verminderung der Störsignale durch die Umschaltung über Zwischenkoeffizientensätze soll hier an einem Beispiel gezeigt werden. Die Anfangs- und Endkoeffizientensätze sind in Tabelle 1 gegeben. Die zugehörigen Frequenzgänge $H_+(e^{j\Omega})$ und $H_-(e^{j\Omega})$ zeigt Figur 3. Als Eingangssignal dient eine Folge von Abtastwerten $u(kT) = \sin\left(\frac{\pi}{6}\,3k\right)$. Diese Frequenz liegt im Minimum der beiden Frequenzgänge. Figur 4a zeigt das Ausgangssignal einer Übertragungsanordnung, bei der direkt, d.h. ohne Einschaltung eines Zwischenkoeffizientensatzes vom Anfangs- auf den Endkoeffizientensatz umgeschaltet wird. M gibt den Umschaltzeitpunkt an. Ein starker Anstieg des Ausgangssignals ist deutlich zu erkennen. Das Ausgangssignal einer Übertragungsanordnung nach der Europäischen Patentanmeldung EP-A-0 135 066 zeigt Figur 4b - g. Hier wird vom Anfangs- auf den Endkoeffizientensatz über eine Anzahl von Zwischenkoeffizientensätzen umgeschaltet, die durch Interpolation gewonnen werden. Der Anstieg des Ausgangssignals läßt sich zwar gegenüber dem direkten Umschalten verringern, es bleibt jedoch ein deutlicher Störanteil. Figur 5 zeigt schließlich das Ausgangssignal einer Übertragungsanordnung nach Figur 1. Der Zwischenkoeffizientensatz wurde dabei nach Anspruch 3 (Fig. 5a), 4 (Fig 5b) und 5 (Fig. 5c) gewählt. Offensichtlich werden die Störanteile so gut wie vollständig eliminiert.

Berechnung der Zwischenkoeffizienten

Die Koeffizienten eines digitalen Filters in Zustandsraumstruktur werden durch die Zustandsmatrizen $\underline{A}$, $\underline{B}$, $\underline{C}$, $\underline{D}$ beschrieben. Diese kann man zur Vereinfachung der Schreibweise in einer Blockmatrix $\underline{S}$ zusammenfassen. Die Koeffizientensätze $\underline{c}_*$ bestehen dann aus den Elementen der Matrizen $\underline{S}_*$

$$\underline{S}_* = \begin{bmatrix} \underline{A}_* & \underline{B}_* \\ \underline{C}_* & \underline{D}_* \end{bmatrix}$$

wobei * für - , $\emptyset$ , + steht. Der Anfangs- und der Endkoeffizientensatz werden durch die Matrizen $\underline{S}_-$ und $\underline{S}_+$ beschrieben. In dieser Schreibweise führt die Minimierung der Differenzsignale gemäß Anspruch 3, 4 und 5 (nach längerer Rechnung) auf Zwischenkoeffizienten beschrieben durch die Matrix $\underline{S}_\emptyset$, die sich aus dem Anfangs- und dem Endkoeffizientensatz nach den Beziehungen

$$\underline{S}_{\emptyset} = \begin{bmatrix} \underline{T}_{3,4} & \emptyset \\ \emptyset & 1 \end{bmatrix} \underline{S}_- \qquad \qquad \text{(Anspruch 3, 4)}$$

bzw.

$$\underline{S}_{\emptyset} = \underline{S}_+ \begin{bmatrix} \underline{T}_5 & \emptyset \\ \emptyset & 1 \end{bmatrix} \qquad \qquad \text{(Anspruch 5)}$$

berechnen lassen.

Für die Matrizen T gilt

$$\underline{T}_3 = \begin{bmatrix} \underline{c}'_+ \\ \underline{c}'_+ \underline{A}_+ \end{bmatrix}^{-1} \begin{bmatrix} \underline{c}'_- \\ \underline{c}'_- \underline{A}_- \end{bmatrix}$$

$$\underline{T}_4 = \underline{W}_{++}^{-1} \underline{W}_{+-}$$

$$\underline{T}_5 = \underline{K}_{+-} \underline{K}_{--}^{-1}$$

$\underline{K}_{12}$ und $\underline{W}_{12}$ sind die (Kreuz-) Kovarianzmatrizen, die allgemein durch

$$\underline{K}_{12} = \sum_{k=0}^{\infty} (\underline{A}_1^k \underline{B}_1)(\underline{A}_2^k \underline{B}_2)'$$

$$\underline{W}_{12} = \sum_{k=0}^{\infty} (\underline{c}_1' \underline{A}_1^k)'(\underline{c}_2' \underline{A}_2^k)$$

definiert sind. 1 und 2 stehen für + oder -. A' bedeutet die zu A transponierte Matrix.

Verschiedene Methoden zur Berechnung der Kreuzkovarianzmatrizen werden im folgenden angegeben.

Berechnung der Kreuzkovarianzmatrizen

1. Allgemeine Zustandsraumstruktur für einen Block 2. Grades (Anspruch 2):

Der Anfangs- und der Endkoeffizientensatz lauten allgemein

$$\underline{A}_- = \begin{bmatrix} a_{11}^- & a_{12}^- \\ a_{21}^- & a_{22}^- \end{bmatrix} \qquad \underline{B}_- = \begin{bmatrix} b_1^- \\ b_2^- \end{bmatrix} \qquad \underline{C}_- = \begin{bmatrix} c_1^- & c_2^- \end{bmatrix} \qquad \underline{D}_- = d^-$$

$$\underline{A}_+ = \begin{bmatrix} a_{11}^+ & a_{12}^+ \\ a_{21}^+ & a_{22}^+ \end{bmatrix} \qquad \underline{B}_+ = \begin{bmatrix} b_1^+ \\ b_2^+ \end{bmatrix} \qquad \underline{C}_+ = \begin{bmatrix} c_1^+ & c_2^+ \end{bmatrix} \qquad \underline{D}_+ = d^+$$

Die Elemente der Matrix $\underline{K}_+$.

$$\underline{K}_{+-} = \begin{bmatrix} k_{11} & k_{12} \\ k_{21} & k_{22} \end{bmatrix}$$

erhält man dann aus der Lösung des Gleichungssystems

$$\begin{bmatrix} 1 - a_{11}^+ a_{11}^- & - a_{11}^+ a_{12}^- & - a_{12}^+ a_{11}^- & - a_{12}^+ a_{12}^- \\ - a_{11}^+ a_{21}^- & 1 - a_{11}^+ a_{22}^- & - a_{12}^+ a_{21}^- & - a_{12}^+ a_{22}^- \\ - a_{21}^+ a_{11}^- & - a_{21}^+ a_{12}^- & 1 - a_{22}^+ a_{11}^- & - a_{22}^+ a_{12}^- \\ - a_{21}^+ a_{21}^- & - a_{21}^+ a_{22}^- & - a_{22}^+ a_{21}^- & 1 - a_{22}^+ a_{22}^- \end{bmatrix} \cdot \begin{bmatrix} k_{11} \\ k_{12} \\ k_{21} \\ k_{22} \end{bmatrix} = \begin{bmatrix} b_1^+ b_1^- \\ b_2^+ b_1^- \\ b_1^+ b_2^- \\ b_2^+ b_2^- \end{bmatrix}$$

Die Matrix $\underline{K}_-$ erhält man durch Ersetzen von + durch -. Die Matrizen $\underline{W}_+$ und $\underline{W}_{++}$ erhält man auf dieselbe Weise, wenn $a_{12}$ und $a_{21}$ vertauscht werden und $b_1$ durch $c_1$ und $b_2$ durch $c_2$ ersetzt wird.

2. Zustandsraumstruktur für einen Block 2. Grades in Normalform:

Für diesen Sonderfall der allgemeinen Zustandsraumstruktur ist eine direkte Berechnung möglich.

2.1 Reelle Pole

Der Anfangs- und der Endkoeffizientensatz lauten allgemein

$$\underline{A}_- = \begin{bmatrix} a_1^- & \varnothing \\ \varnothing & a_2^- \end{bmatrix} \qquad \underline{B}_- = \begin{bmatrix} b_1^- \\ b_2^- \end{bmatrix} \qquad \underline{C}_- = \begin{bmatrix} c_1^- & c_2^- \end{bmatrix} \qquad \underline{D}_- = d^-$$

$$\underline{A}_+ = \begin{bmatrix} a_1^+ & \varnothing \\ \varnothing & a_2^+ \end{bmatrix} \qquad \underline{B}_+ = \begin{bmatrix} b_1^+ \\ b_2^+ \end{bmatrix} \qquad \underline{C}_+ = \begin{bmatrix} c_1^+ & c_2^+ \end{bmatrix} \qquad \underline{D}_+ = d^+$$

Die Elemente der Matrix $\underline{K}_{+-}$ lauten

$$k_{ij} = \frac{b_i^+ b_j^-}{1 - a_i^+ a_j^-} \qquad i,j = 1,2$$

2.2 Konjugiert Komplexe Pole

Der Anfangs- und der Endkoeffizientensatz lauten allgemein

$$\underline{A}_- = \begin{bmatrix} a_1^- & a_2^- \\ -a_2^- & a_1^- \end{bmatrix} \qquad \underline{B}_- = \begin{bmatrix} b_1^- \\ b_2^- \end{bmatrix} \qquad \underline{C}_- = \begin{bmatrix} c_1^- & c_2^- \end{bmatrix} \qquad \underline{D}_- = d^-$$

$$\underline{A}_+ = \begin{bmatrix} a_1^+ & a_2^+ \\ -a_2^+ & a_1^+ \end{bmatrix} \qquad \underline{B}_+ = \begin{bmatrix} b_1^+ \\ b_2^+ \end{bmatrix} \qquad \underline{C}_+ = \begin{bmatrix} c_1^+ & c_2^+ \end{bmatrix} \qquad \underline{D}_+ = d^+$$

Die Elemente der Matrix $\underline{K}_{+-}$ erhält man schrittweise aus

$$P_R = \frac{1}{2} \left( b_1^+ b_1^- + b_2^+ b_2^- \right) \qquad\qquad P_I = \frac{1}{2} \left( b_1^+ b_2^- - b_2^+ b_1^- \right)$$

$$Q_R = 1 - \left( a_1^+ a_1^- + a_2^+ a_2^- \right) \qquad\qquad Q_I = a_2^+ a_1^- - a_1^+ a_2^-$$

$$S_R = \frac{1}{2} \left( b_1^+ b_1^- - b_2^+ b_2^- \right) \qquad\qquad S_I = - \frac{1}{2} \left( b_1^+ b_2^- + b_2^+ b_1^- \right)$$

$$T_R = 1 - \left( a_1^+ a_1^- - a_2^+ a_2^- \right) \qquad\qquad T_I = a_1^+ a_2^- + a_2^+ a_1^-$$

$$A_R = \frac{P_R Q_R + P_I Q_I}{Q_R^2 + Q_I^2} \qquad\qquad B_R = \frac{S_R T_R + S_I T_I}{T_R^2 + T_I^2}$$

$$A_I = \frac{P_I Q_R - P_R Q_I}{Q_R^2 + Q_I^2} \qquad\qquad B_I = \frac{S_I T_R - S_R T_I}{T_R^2 + T_I^2}$$

$$k_{11} = A_R + B_R \qquad\qquad k_{12} = A_I - B_I$$

$$k_{21} = - A_I - B_I \qquad\qquad k_{22} = A_R - B_R$$

Die anderen Matrizen erhält man wie unter 1. beschrieben.

Anfangskoeffizientensatz                    Endkoeffizientensatz

$$A_- = \begin{pmatrix} 0,9514806 & 3,7822104\cdot 10^{-3} \\ \\ -3,7822104\cdot 10^{-3} & 0,9514806 \end{pmatrix} \qquad A_+ = \begin{pmatrix} 0,9596681 & 0 \\ \\ 0 & 0,9723652 \end{pmatrix}$$

$$B_- = \begin{pmatrix} 4,50276028\cdot 10^{-2} \\ \\ 4,85798208\cdot 10^{-2} \end{pmatrix} \qquad B_+ = \begin{pmatrix} 3,0331910\cdot 10^{-2} \\ \\ -7,7634811\cdot 10^{-2} \end{pmatrix}$$

$$C_- = \begin{pmatrix} 10,66239 \\ \\ -11,50351 \end{pmatrix} \qquad C_+ = \begin{pmatrix} 1,978881 \\ \\ 1,931385 \end{pmatrix}$$

$$D_- = 0,9536236 \qquad\qquad\qquad D_+ = 0,9524227$$

Tabelle 1

## Patentansprüche

1. Digitale Übertragungsanordnung, die mit codierten Abtastproben arbeitet und deren Übertragungsfunktion ohne Betriebsunterbrechung ausgehend von einer Anfangsübertragungsfunktion störungsarm bis zu einer Endübertragungsfunktion verändert werden kann, mit Umschaltmitteln für die jeweils einem Übertragungsglied (1) der Übertragungsanordnung zuzuordnenden Übertragungskoeffizienten zur Umschaltung von einem Anfangskoeffizientensatz auf einen Endkoeffizientensatz, dadurch gekennzeichnet, daß die Umschaltmittel (S1) ausgebildet sind zur Einschaltung eines einzigen Zwischenkoeffizientensatzes ($c_0$) zwischen dem Anfangs- ($c_-$) und dem Endkoeffizientensatz ($c_+$) und daß Mittel vorgesehen sind, mit denen der Zwischenkoeffizientensatz ($c_0$) in Abhängigkeit vom Anfangs- ($c_-$) und Endkoeffizientensatz ($c_+$) derart bestimmt wird, daß die beim Umschalten zu erwartende Störleistung minimiert wird.

2. Übertragungseinrichtung nach Anspruch 1, dadurch gekennzeichnet, daß die Übertragungsanordnung durch ein digitales Filter zweiten Grades in Zustandsraumstruktur realisiert wird.

3. Übertragungseinrichtung nach Anspruch 1 oder 2, dadurch gekennzeichnet, daß der Zwischenkoeffi-

zientensatz ($c_0$) so gewählt wird, daß bei Erregung der Übertragungsanordnung (1) mit einem Zufallssignal beliebiger Leistungsdichte der quadratische Erwartungswert $E(d^2(k))$ des Differenzsignals $d_-(k) = y$-(kT)-$y_-$(kT) zwischen dem Ausgangssignal $y$(kT) der mit dem Zwischenkoeffizientensatz ($c_0$) betriebenen Übertragungsanordnung (1) und dem Ausgangssignal $y_-$(kT) der mit dem Anfangskoeffizientensatz ($c_-$) betriebenen Übertragungsanordnung (1) für k = 0, 1, 2 minimal wird, wenn die Umschaltmittel (S1) für k < 0 den Koeffizientensatz $c_-$, für k = 0 den Koeffizientensatz $c_0$ und für k > 0 den Koeffizientensatz $c_+$ anlegen, wobei k eine beliebige ganze Zahl ist und T das Abtastintervall für ein analoges und digital weiterzuverarbeitendes Signal ist, mithin die Variable kT also die in Abständen des Abtastintervalls diskretisierte Zeitachse darstellt.

4. Übertragungseinrichtung nach Anspruch 1 oder 2, dadurch gekennzeichnet, daß der Zwischenkoeffizientensatz $c_0$ so gewählt wird, daß bei Erregung der Übertragungsanordnung (1) mit einem Zufallssignal beliebiger Leistungsdichte die Summe

$$\sum_{k=0}^{\infty} E(d_-^2(k))$$

der quadratischen Erwartungswerte $E(d^2(k))$ des Differenzsignals $d_-(k) = y(kT)$-$y_-$(kT) zwischen dem Ausgangssignal $y$(kT) der mit dem Zwischenkoeffizientensatz $c_0$ betriebenen Übertragungsanordnung und dem Ausgangssignal $y_-$(kT) der mit dem Anfangskoeffizientensatz $c_-$ betriebenen Übertragungsanordnung (1) für alle k ≥ 0 minimal wird, wenn die Umschaltmittel (S1) für k < 0 den Koeffizientensatz $c_-$, für k = 0 den Koeffizientensatz $c_0$ und für k > 0 den Koeffizientensatz $c_+$ anlegen, wobei k eine beliebige ganze Zahl ist und T das Abtastintervall für ein analoges und digital weiterzuverarbeitendes Signal ist, mithin die Variable kT also die in Abständen des Abtastintervalls diskretisierte Zeitachse darstellt.

5. Übertragungseinrichtung nach Anspruch 1 oder 2, dadurch gekennzeichnet, daß der Zwischenkoeffizientensatz $c_0$ so gewählt wird, daß bei Erregung der Übertragungsanordnung (1) mit einem Zufallssignal beliebiger Leistungsdichte die Summe

$$\sum_{k=0}^{\infty} E(d_+^2 k))$$

der quadratischen Erwartungswerte $E(d_+^2 (k))$ des Differenzsignals $d_+(k) = y(kT)$-$y_+$(kT) zwischen dem Ausgangssignal $y$(kT) der mit dem Zwischenkoeffizientensatz $c_0$ betriebenen Übertragungsanordnung (1) und dem Ausgangssignal $y_+$(kT) der mit dem Endkoeffizientensatz $c_+$ betriebenen Übertragungsanordnung (1) für alle k ≥ 0 minimal wird, wenn die Umschaltmittel (s1) für k < 0 den Koeffizientensatz $c_-$, für k = 0 den Koeffizientensatz $c_0$ und für k > 0 den Koeffizientensatz $c_+$ anlegen, wobei k eine beliebige ganze Zahl ist und T das Abtastintervall für ein analoges und digital weiterzuverarbeitendes Signal ist, mithin die Variable kT also die in Abständen des Abtastintervalls diskretisierte Zeitachse darstellt.

6. Übertragungseinrichtung nach Anspruch 1, dadurch gekennzeichnet, daß mehrere Übertragungseinrichtungen in Kaskade oder parallel geschaltet sind.

7. Übertragungseinrichtung nach Anspruch 1, gekennzeichnet durch die Kaskadierung einer Übertragungseinrichtung nach Anspruch 3 mit einer Übertragungseinrichtung nach Anspruch 4 oder mit einer Übertragungseinrichtung nach Anspruch 5.

8. Übertragungseinrichtung nach Anspruch 1, gekennzeichnet durch die Parallelschaltung einer Übertragungseinrichtung nach Anspruch 3 mit einer Übertragungseinrichtung nach Anspruch 4 oder mit einer Übertragungseinrichtung nach Anspruch 5.

**Claims**

1. A digital transmission arrangement operating with coded scanning samples and whose transfer function can be changed without interrupting operation and with low interference starting from a starting transfer function to a final transfer function, the arrangement including switching means for the transmission coefficients to be associated with each transmission member (1) of the transmission arrangement for switching from a set of starting coefficients to a set of final coefficients, characterised in that the switching means (S1) are configured to switch in a single set of intermediate coefficients ($c_0$) between the set of starting coefficients ($c_-$) and the set of final coefficients ($c_+$); and means are provided with which the set of intermediate coefficients ($c_0$) is determined as a function of the set of starting coefficients ($c_-$) and the set of final coefficients ($c_+$) so that the interference to be expected during switching is minimised.

2. A transmission device according to Claim 1, characterised in that the transmission arrangement is realised by a second degree digital filter in state space structure.

3. A transmission device according to Claim 1 or 2, characterised in that the set of intermediate coefficients ($c_0$)is selected in such a manner that, upon excitation of the transmission arrangement (1) with an arbitrary signal of a desired power density, the square of the expected value ($E(d^2_-(k))$) of the difference signal $d_-(k) = y(kT)-y_-(kT)$ between the output signal $y(kT)$ of the transmission arrangement (1) operated with the set of intermediate coefficients ($c_0$) and the output signal $y_-(kT)$ of the transmission arrangement (1) operated with the set of starting coefficients ($c_-$) becomes a minimum for $k = 0, 1, 2$ if the switching means (S1) apply the set of coefficients $c_-$ for $k < 0$, the set of coefficients $c_0$ for $k = 0$ and the set of coefficients $c_+$ for $k > 0$, with k representing an arbitrary integer and T representing the sampling interval for an analog signal and a digital signal to be further processed, while thus the variable kT represents the time axis which has been made discrete at the spacing of the sampling interval.

4. Transmission device according to Claim 1 or 2, characterised in that the set of intermediate coefficients $c_0$ is selected in such a manner that, upon excitation of the transmission arrangement (1) with an arbitrary signal of a desired power density, the sum

$$\sum_{k=0}^{\infty} E(d^2_-(k))$$

of the expected values ($E(d^2(k))$) of the squares of the difference signal $d_-(k) = y(kT)-y_-(kT)$ between the output signal $y(kT)$ of the transmission arrangement (1) operated with the set of intermediate coefficients ($c_0$) and the output signal $y_-(kT)$ of the transmission arrangement (1) operated with the set of starting coefficients ($c_-$) becomes a minimum for all $k \geq 0$ if the switching means (S1) apply the set of coefficients $c_-$ for $k < 0$, the set of coefficients $c_0$ for $k = 0$ and the set of coefficients $c_+$ for $k > 0$, with k representing an arbitrary integer and T representing the sampling interval for an analog signal and a digital signal to be further processed, while thus the variable kT represents the time axis which has been made discrete at the spacing of the sampling interval.

5. Transmission device according to Claim 1 or 2, characterised in that the set of intermediate coefficients $c_0$ is selected in such a manner that, upon excitation of the transmission arrangement (1) with an arbitrary signal of a desired power density, the sum

$$\sum_{k=0}^{\infty} E(d^2_+(k))$$

of the expected values ($E(d^2_+(k))$) of the squares of the difference signal $d_+(k) = y(kT)-y_+(kT)$ between the output signal $y(kT)$ of the transmission arrangement (1) operated with the set of intermediate coefficients ($c_0$) and the output signal $y_+(kT)$ of the transmission arrangement (1) operated with the set of final coefficients ($c_+$) becomes a minimum for all $k \geq 0$ if the switching means (S1) apply the set of

10

EP 0 276 394 B1

coefficients $c_-$ for $k < 0$, the set of coefficients $c_0$ for $k = 0$ and the set of coefficients $c_+$ for $k > 0$, with k representing an arbitrary integer and T representing the sampling interval for an analog signal and a digital signal to be further processed, while thus the variable kT represents the time axis which has been made discrete at the spacing of the sampling interval.

6. Transmission device according to Claim 1, characterised in that a plurality of transmission devices are connected in cascade or in parallel.

7. Transmission device according to Claim 1, characterised in that a transmission device according to Claim 3 is connected in cascade with a transmission device according to Claim 4 or with a transmission device according to Claim 5.

8. Transmission device according to Claim 1, characterised in that a transmission device according to Claim 3 is connected in parallel with a transmission device according to Claim 4 or with a transmission device according to Claim 5.

**Revendications**

1. Dispositif de transmission numérique opérant avec des échantillons et ayant une fonction de transfert qui, sans interruption du fonctionnement, peut être modifiée en passant d'une fonction de transfert initiale à une fonction de transfert finale, ce dispositif comportant, pour les coefficients de transfert affectés chacun à un élément de transmission (1) de ce dispositif de transmission, des moyens de commutation pour passer d'un jeu de coefficients initial à un jeu de coefficients final, caractérisé par le fait que les moyens de commutation (S1) sont conçus-réalisés pour l'intervention d'un seul jeu de coefficients intermédiaire ($c_0$) entre le jeu de coefficients initial ($c_-$) et le jeu de coefficients final ($c_+$), et par le fait que des moyens sont prévus avec lesquels le jeu de coefficients intermédiaire ($c_0$) est déterminé en fonction du jeu de coefficients initial ($c_-$) et du jeu de coefficients final ($c_+$), de manière telle que la puissance de bruit perturbateur escomptée lors de la commutation soit minimisée.

2. Dispositif de transmission selon revendication 1, caractérisé par le fait que le dispositif de transmission est réalisé par un filtre numérique du deuxième degré en structure d'espace d'état.

3. Dispositif de transmission selon revendication 1 ou 2, caractérisé par le fait que le jeu de coefficients intermédiaire ($c_0$) est choisi de manière telle qu'en cas d'excitation du dispositif de transmission (1) avec un signal aléatoire ayant une densité de puissance quelconque désirée la valeur quadratique escomptée $E(d^2[k])$ du signal de différence, $d_-(k) = y(kT) - y_-(kT)$, entre le signal de sortie $y(kT)$ du dispositif de transmission (1) utilisé avec le jeu de coefficients intermédiaire ($c_0$) et le signal $y_-(kT)$ de sortie du dispositif de transmission (1) utilisé avec le jeu de coefficients initial ($c_-$) soit minimale pour k = 0, 1, 2, lorsque les moyens de commutation (S1) appliquent pour $k < 0$ le jeu de coefficients $c_-$, pour $k = 0$ le jeu de coefficients $c_0$ et, pour $k > 0$, le jeu de coefficients $c_+$, k étant un entier quelconque désiré et T l'intervalle d'échantillonnage pour un signal analogique devant être traité numériquement, la variable kT représentant par conséquent l'axe du temps discrétisé en distances de l'intervalle d'échantillonnage.

4. Dispositif de transmission selon revendication 1 ou 2, caractérisé par le fait que le jeu de coefficients intermédiaire $c_0$ est choisi de manière qu'en cas d'excitation du dispositif de transmission avec un signal aléatoire ayant une densité de puissance quelconque désirée, la somme

$$\sum_{k=0}^{\infty} E(d_-^2[k])$$

de la valeur quadratique escomptée $E(d^2[k])$ du signal de différence, $d_-(k) = y(kT) - y_-(kT)$, entre le signal de sortie $y(kT)$ du dispositif de transmission utilisé avec le jeu de coefficients intermédiaire ($c_0$) et le signal de sortie $y_-(kT)$ du dispositif de transmission (1) utilisé avec le jeu de coefficients initial ($c_-$) soit minimale pour tout $k \geq 0$, lorsque les moyens de commutation (S1) appliquent pour $k < 0$ le jeu de coefficients $c_-$, pour $k = 0$ le jeu de coefficients $c_0$ et, pour $k > 0$, le jeu de coefficients $c_+$, k étant un entier quelconque désiré et T étant l'intervalle d'échantillonnage pour un signal analogique devant être traité numériquement, la variable kT représentant par conséquent l'axe du temps discrétisé en distances de l'intervalle d'échantillonnage.

5. Dispositif de transmission selon revendication 1 ou 2, caractérisé par le fait que le jeu de coefficients intermédiaire $c_0$ est choisi de manière qu'en cas d'excitation du dispositif de transmission avec un signal aléatoire ayant une densité de puissance quelconque désirée, la somme

$$\sum_{k=0^+}^{\infty} E(d^2(k))$$

de la valeur quadratique escomptée $E(d_+^2[k])$ du signal de différence, $d_+(k) = y(kT) - y_+(kT)$, entre le signal de sortie $y(kT)$ du dispositif de transmission utilisé avec le jeu de coefficients intermédiaire ($c_0$) et le signal de sortie $y_+(kT)$ du dispositif de transmission (1) utilisé avec le jeu de coefficients final ($\overline{c_+}$) soit minimale pour tout $k \geq 0$, lorsque les moyens de commutation (S1) appliquent pour $k < 0$ le jeu de coefficients $c_-$, pour $k = 0$ le jeu de coefficients $c_0$ et, pour $k > 0$, le jeu de coefficients $c_+$, k étant un entier quelconque désiré et T étant l'intervalle d'échantillonnage pour un signal analogique devant être traité numériquement, la variable kT représentant par conséquent l'axe du temps discrétisé en distances de l'intervalle d'échantillonnage.

6. Dispositif de transmission selon revendication 1, caractérisé par le fait que plusieurs dispositifs de transmission sont montés en cascade ou en parallèle.

7. Dispositif de transmission selon revendication 1, caractérisé par le fait qu'un dispositif de transmission selon revendication 3 est monté en cascade avec un dispositif de transmission selon revendication 4 ou avec un dispositif de transmission selon revendication 5.

8. Dispositif de transmission selon revendication 1, caractérisé par le fait qu'un dispositif de transmission selon revendication 3 est monté en parallèle d'un dispositif de transmission selon revendication 4 ou d'un dispositif de transmission selon revendication 5.

FIG. 1

FIG. 2

13

$-20 \cdot \log |H_{+,-}(e^{j\Omega})|$

Frequenzgänge von Start- und Zielfilter (Bandsperre)

Startfilter

Zielfilter

Abtastfrequenz: $f_A = 50,4\,kHz$
Umrechnung: $\Omega = 2\pi\, f / f_A$
(Darstellung nach Meßkurven
der Firma ANT)

FIG. 3

Frequenz f/kHz

EP 0 276 394 B1

Vergleich von direktem Umschalten mit der Interpolationsmethode
a) direktes Umschalten
b) 1 Zwischenschritt

FIG. 4

c) 3 Zwischenschritte
d) 7 Zwischenschritte
e) 15 Zwischenschritte

FIG. 4

f) 31 Zwischenschritte
g) 63 Zwischenschritte

FIG. 4

Umschalten mit einem Zwischenschritt (Minimierungsverfahren)
a) Minimierung der Varianz von $d_-(k)$ Wert für Wert
b) Minimierung der Varianz von $d_-(k)$ für alle Werte k
c) Minimierung der Varianz von $d_+(k)$

FIG. 5